# FASCICULE DE BREVET EUROPEEN

(11) **EP 1 727 152 B1**
(45) Date de publication et mention de la délivrance du brevet: **24.12.2008**
(21) Numéro de dépôt: 06007652.8
(22) Date de dépôt: 12.04.2006
(51) Int. Cl.: G11C 16/04

(54) **Architecture de mémoire EEPROM**
EEPROM-Speicherarchitektur
EEPROM memory architecture

(30) Priorité: 18.05.2005 FR 0504946
(43) Date de publication de la demande: 29.11.2006
(73) Titulaire: STMicroelectronics SA, 92210 Montrouge (FR)
(72) Inventeur: La Rosa, Francesco, 13790 Rousset (FR)
(74) Mandataire: Marchand, André

(56) Documents cités:
- US-A- 5 677 871
- US-A- 5 963 478

## Description

La présente invention concerne les mémoires effaçables et programmables électriquement.

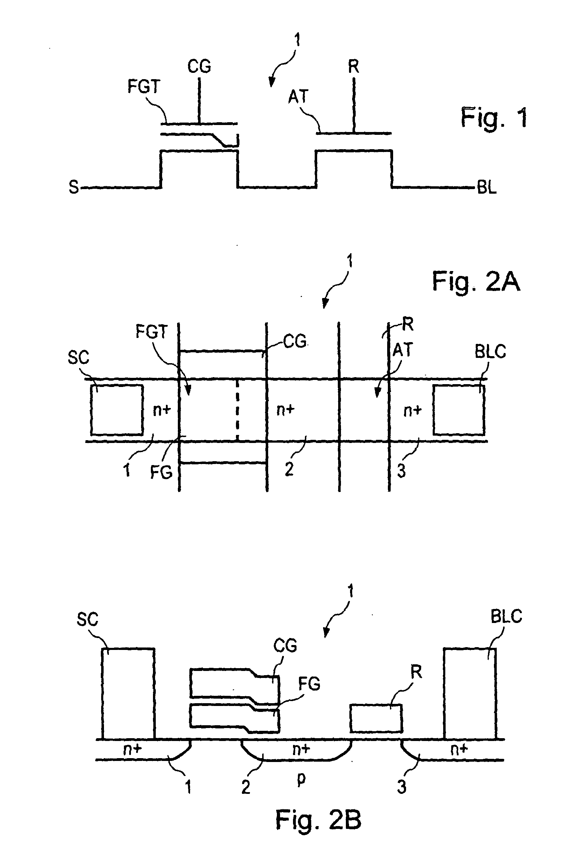

La présente invention concerne plus particulièrement une mémoire effaçable et programmable, comprenant des cellules mémoire comportant chacune un transistor à grille flottante connecté en série avec un transistor d'accès de type MOS. La figure 1 représente un exemple de cellule mémoire EEPROM du type précité comprenant un transistor à grille flottante FGT dont le drain est connecté à la source d'un transistor d'accès AT. La grille du transistor AT est connectée à une ligne de mot R et le drain du transistor AT est connecté à une ligne de bit BL.

Les figures 2A et 2B montrent respectivement en vue de dessus et en coupe transversale, la cellule représentée sur la figure 1. Cette cellule est réalisée dans un substrat de type p dans lequel sont formées trois régions 1, 2, 3 dopées n+ formant respectivement la région de drain du transistor FGT, la région de drain du transistor FGT et la région de source du transistor AT, et enfin la région de drain du transistor AT. La cellule mémoire comprend :
- une borne SC de source du transistor FGT, réalisée sur la région de source 1 du transistor FGT,
- une grille flottante FG et une grille de contrôle CG superposées du transistor FGT, qui sont formées au-dessus d'une région intermédiaire entre les régions 1 et 2, et au-dessus d'une portion de la région 2,
- une grille R du transistor AT formée au-dessus d'une région intermédiaire entre les régions 2 et 3, et
- une borne de drain BLC du transistor AT, formée sur la région de drain 3 du transistor AT.

Le fonctionnement d'une telle cellule-mémoire est basé sur l'effet tunnel (ou effet Fowler-Nordheim) et consiste à induire des déplacements de la tension de seuil du transistor FGT en injectant ou en retirant des charges de la grille flottante FG au travers d'une fine couche d'oxyde séparant la région dopée 2 et la grille flottante. Une opération d'effacement ou de programmation de la cellule mémoire consiste dans l'injection ou l'extraction de charges électriques par effet Fowler-Nordheim dans la grille flottante du transistor FGT. Le transistor FGT présente une tension de seuil VT1 (égale à environ -2 V) à l'état programmé, et une tension de seuil VT2 (égale à environ 4 V) à l'état effacé supérieure à la tension VT1. Lorsqu'une tension de lecture Vread comprise entre VT1 et VT2 est appliquée sur sa grille de contrôle CG, le transistor FGT reste bloqué s'il est effacé, ce qui correspond par convention à un "0" logique, et est passant s'il est programmé, ce qui correspond à un "1" logique. Bien entendu, une convention inverse peut être retenue.

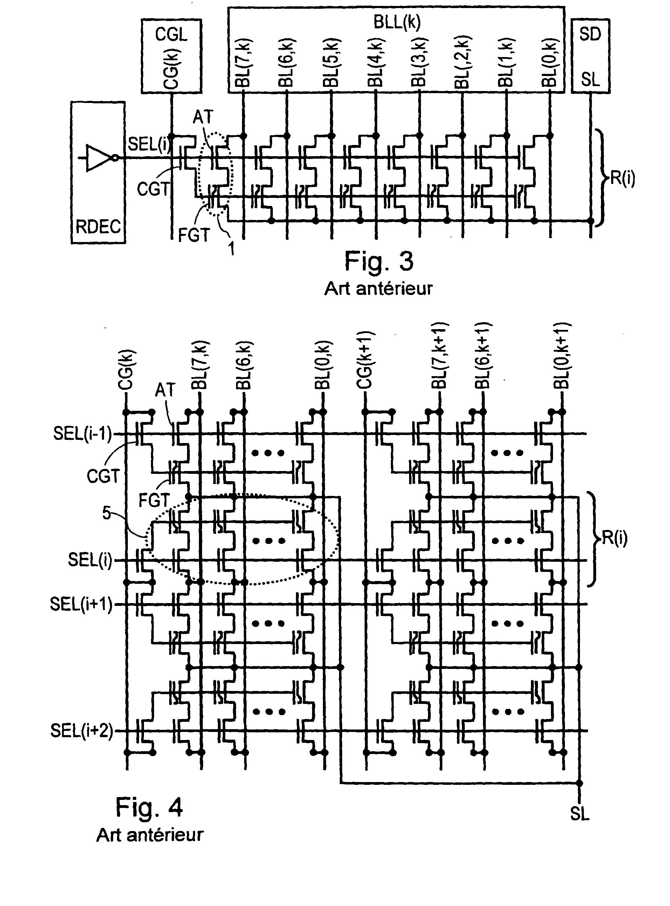

La figure 3 représente un exemple de mémoire EEPROM du type précité. La mémoire comprend des groupes de M cellules mémoire permettant chacun de mémoriser un mot de M bits (8 dans l'exemple de la figure, soit un octet). Dans un souci de simplicité, un seul groupe de cellules mémoire appartenant à une colonne de rang k et à une ligne de mot R(i) de rang i est présenté sur cette figure. Ce groupe de cellules mémoire assemblées en ligne comprend un transistor CGT de contrôle de grille dont la source est connectée à toutes les grilles des transistors FGT du groupe, et dont la grille est connectée à toutes les grilles des transistors d'accès AT du groupe et à une ligne de sélection SEL(i). Les sources des transistors FGT des cellules mémoire sont connectées à une ligne source SL globale, généralement contrôlée par un simple transistor qui la met à la masse ou à haute impédance. Chacun des drains des transistors AT du groupe est connecté à une ligne de bit BL(j,k) (j étant un nombre entier compris entre 0 et M-1). Le transistor CGT permet de connecter les grilles des transistors FGT du groupe de cellules mémoire à une ligne de contrôle de grilles CG(k) du groupe. De cette manière, les cellules peuvent être effacées en parallèle en les plaçant dans un état par convention associé à la valeur 0, dans lequel elles présentent une valeur élevée de tension de seuil.

Les opérations d'effacement et de programmation des cellules mémoire sont réalisées à l'aide de verrous de ligne de bit BL(j,k) regroupés dans des ensembles BLL de verrous de ligne de bit, de verrous CGL de lignes de contrôle de grilles, d'un décodeur RDEC de lignes de mot présentant une sortie par ligne de mot R(i), et d'une unité de contrôle de colonne SD.

La figure 4 représente un ensemble de 8 groupes de cellules mémoire, tels qu'illustrés sur la figure 3, permettant chacun de mémoriser un mot. Sur cette figure, les groupes sont associés en colonnes de rangs k, k+1 et en lignes de mot de rangs i-1, i, i+1, i+2. Ainsi, chaque ligne de sélection SEL(i) est connectée aux grilles des transistors AT des groupes situés sur la même ligne. Les lignes de source des groupes de chaque colonne sont connectées à une ligne de source globale SL.

L'effacement collectif des transistors FGT d'un groupe de cellules mémoire appartenant à une ligne de mot de rang i et une colonne de rang k, est obtenu en appliquant une tension Vpp1, par exemple 12 V, sur la grille de contrôle CG des transistors FGT, par l'intermédiaire du transistor de contrôle de grille CGT du groupe, pendant que la ligne de source SL est placée à 0 volt et que le drain des transistors FGT via les transistors d'accès AT est à un potentiel flottant ou à haute impédance. La programmation individuelle de transistors FGT est effectuée en appliquant la tension Vpp1 aux drains des transistors FGT via les transistors d'accès, pendant que la grille de contrôle des transistors FGT est à 0 volt, et que la ligne de source SL est mise à un potentiel flottant.

Le tableau 1 ci-après résume les valeurs des signaux de contrôle appliqués pendant les opérations d'effacement, de programmation et de lecture de cellules mémoire.

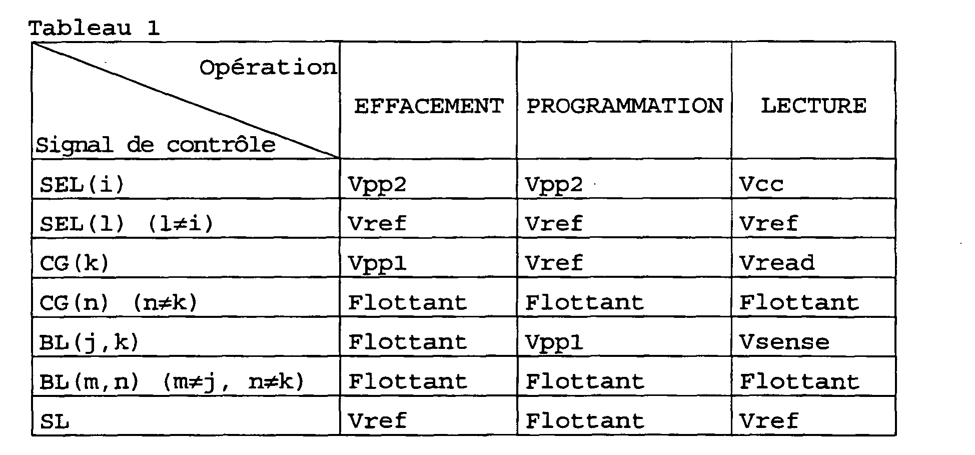

Dans ce tableau, la tension Vref est égale à 0 V (masse), la tension Vpp2 est égale à 15 V, la tension Vcc est comprise entre 3 et 5 V, la tension Vread est comprise entre les tensions de seuil VT1 et VT2 et la tension Vsense est de l'ordre de 1 V.

Il s'avère que les courants résultant de l'effet tunnel Fowler-Nordheim dans les transistors FGT dépendent principalement de l'épaisseur de la couche d'oxyde tunnel séparant la région dopée 2 et la grille flottante FG, et du champ électrique qui est proportionnel à la tension appliquée au transistor à grille flottante FGT et au facteur de couplage capacitif entre sa grille flottante FG et sa grille de contrôle CG, par rapport au couplage de cette dernière avec le drain et la source du transistor, ainsi qu'avec le reste de la cellule.

Il est connu que la tension de seuil VT d'un transistor à grille flottante augmente si l'on augmente la tension qui lui est appliquée et son facteur de couplage, et si l'on réduit l'épaisseur de la couche d'oxyde. Or si l'on réduit cette épaisseur, on réduit également la durée pendant laquelle la grille flottante peut conserver sa charge, c'est-à-dire la durée de mémorisation d'une donnée par la cellule mémoire, qui devrait être de plusieurs années. Par conséquent, si l'on souhaite augmenter la rapidité de la mémoire, c'est-à-dire réduire la durée des opérations de programmation et d'effacement, ce résultat peut être atteint en augmentant les tensions appliquées et en réduisant le facteur de couplage. Le facteur de couplage peut difficilement être réduit, surtout si l'on cherche en même temps à réduire la taille des cellules mémoire. L'augmentation des tensions appliquées aux cellules mémoire est également limitée par la tension de claquage des jonctions drain ou source entre les régions dopées n+ et le substrat p. Cette tension de claquage dépend de la technologie employée. Dans l'exemple décrit ci-avant, la tension de claquage est légèrement supérieure à 12 V. Il n'est donc pas possible d'appliquer aux jonctions (drain-grille) des transistors des écarts de tension supérieurs à 12 V.

Les brevet US 5 677 871 et US 5 963 478 décrivent des mémoires EEPROM dans lesquelles les grilles de contrôle des transistors à grille flottante des cellules mémoire d'une même ligne de mot sont connectées à une ligne de contrôle de grille commune, les grilles des transistors d'accès d'une même ligne de mot sont connectées à une ligne de mot commune, et les sources des transistors à grille flottante de plusieurs cellules sont reliées à une ligne de source commune.

Un objectif de la présente invention est de permettre d'appliquer aux jonctions drain-grille des transistors des écarts de tension supérieurs à 12 V.

Cet objectif est atteint par la prévision d'une mémoire effaçable et programmable électriquement dans laquelle on a supprimé les transistors CGT de contrôle de grille, les cellules mémoire d'une ligne de mot étant commandées par une ligne de sélection commune connectée aux grilles des transistors d'accès des cellules mémoire de la ligne de mot, et par une ligne de contrôle de grille commune connectée aux grilles de contrôle des transistors à grille flottante des cellules mémoire de la ligne de mot. De cette manière la tension applicable aux grilles des transistors à grille flottante n'est plus limitée par la tension susceptible d'être obtenue sur la source des transistors de contrôle de grille.

Avec une telle architecture, l'obtention d'une mémoire du type effaçable par mot ou effaçable par page est déterminée par un mode d'interconnexion des sources des transistors FGT dans lequel des lignes de source indépendantes sont attribuées aux colonnes et sont pilotées par des unités de contrôle de colonne.

Plus particulièrement, l'invention prévoit une mémoire effaçable et programmable électriquement comprenant :
- des cellules mémoire, chaque cellule mémoire comprenant un transistor à grille flottante agencé en série avec un transistor d'accès,
- des lignes de sélection de lignes de mot connectées chacune aux grilles des transistors d'accès des cellules mémoire d'une ligne de mot respective, des lignes de bit transversales aux lignes de mot et reliées aux cellules mémoire, les lignes de bit étant regroupées en colonnes sélectionnables individuellement,
- des lignes de contrôle de grille communes connectées chacune aux grilles de contrôle des transistors à grille flottante des cellules mémoire d'une ligne de mot respective, et
- des lignes de source communes qui sont connectées chacune aux cellules mémoire d'une colonne respective, et
- des unités de contrôle de colonne pilotant chacune une ligne de source respective.

Selon l'invention, la mémoire comprend un double caisson dans un substrat semi-conducteur, dans lequel sont formées les cellules mémoire, et des moyens pour polariser le double caisson à une tension de polarisation positive durant des opérations de programmation de cellules mémoire.

Selon un mode de réalisation de l'invention, l'unité de contrôle de colonne de chaque colonne reçoit un signal de sélection de colonne et est agencée pour appliquer des tensions différentes à la ligne de source de la colonne selon que la colonne est sélectionnée ou non.

Selon un mode de réalisation de l'invention, pendant une phase d'effacement de cellules mémoire d'une colonne sélectionnée :
- l'unité de contrôle de colonne de la colonne sélectionnée applique une première tension à la ligne de source de la colonne sélectionnée, et
- l'unité de contrôle de colonne d'une colonne non sélectionnée applique à la ligne de source de la colonne non sélectionnée une tension d'inhibition d'effacement.

Selon un mode de réalisation de l'invention, pendant une phase d'effacement de cellules mémoire d'une ligne de mot sélectionnée, une unité de décodage de ligne applique une tension positive et une tension de référence respectivement à la ligne de contrôle de grille et à la ligne de sélection de la ligne de mot sélectionnée.

Selon un mode de réalisation de l'invention, pendant une phase de programmation de cellules mémoire d'une ligne de mot sélectionnée, une unité de décodage de ligne applique :
- une première tension de référence positive à la ligne de contrôle de grille d'une ligne de mot non sélectionnée,
- une seconde tension de référence positive ou nulle inférieure à la première tension de référence à la ligne de contrôle de grille de la ligne de mot sélectionnée, et
- une tension positive à la ligne de sélection de la ligne de mot sélectionnée.

Selon un mode de réalisation de l'invention, la première tension de référence est une tension positive inférieure à la tension positive, et la seconde tension de référence est nulle.

Selon un mode de réalisation de l'invention, la tension positive est comprise entre 15 et 21 V, et la première tension de référence est comprise entre 2 et 5 V.

Selon un mode de réalisation de l'invention, des verrous de programmation de lignes de bit placent sélectivement les lignes de bits à un potentiel flottant, et à une première tension de référence.

Selon un mode de réalisation de l'invention, pendant une opération de programmation de cellules mémoire reliées à des lignes de bit sélectionnées, des verrous de programmation des lignes de bit sélectionnées appliquent une seconde tension positive aux lignes de bits sélectionnées.

L'invention concerne également un procédé de sélection de cellules mémoire dans une mémoire effaçable et programmable électriquement comprenant :
- des cellules mémoire comprenant un transistor à grille flottante agencé en série avec un transistor d'accès,
- les cellules mémoire étant réalisées dans un double caisson formé dans un substrat semi-conducteur, et agencées selon des lignes de mot et selon des colonnes de mot transversales aux lignes de mot,
- des lignes de sélection connectées chacune aux grilles des transistors d'accès des cellules mémoire d'une ligne de mot respective,
- des lignes de contrôle de grille connectées chacune aux grilles des transistors à grille flottante des cellules mémoire d'une ligne de mot respective,
- des lignes de sélection de colonne reliées chacune aux transistors à grille flottante des cellules mémoire d'une colonne respective.

Selon l'invention, le procédé comprend des étapes de :
- polarisation du double caisson (8) à une tension de polarisation positive,
- application d'une première tension positive de référence (Vref1) à une ligne de contrôle de grille (CGL(1)) d'une ligne de mot non sélectionnée,
- application d'une première tension positive à la ligne de sélection d'une ligne de mot sélectionnée,
- application d'une seconde tension positive ou nulle à la ligne de contrôle de grille de la ligne de mot sélectionnée.

Selon un mode de réalisation de l'invention,
- la première tension de référence est appliquée à une ligne de sélection de colonne d'une colonne sélectionnée, et
   une tension d'inhibition d'effacement distincte de la première tension de référence est appliquée à une ligne de sélection de colonne d'une colonne non sélectionnée.

Selon un mode de réalisation de l'invention, pendant une phase d'effacement des cellules mémoire sélectionnées, la seconde tension est égale à une tension positive, la première tension est égale à la première tension de référence.

Selon un mode de réalisation de l'invention, la tension positive est comprise entre 15 et 21 V, et la tension d'inhibition est comprise entre 10 et 15 V.

Selon un mode de réalisation de l'invention, pendant une phase de programmation des cellules mémoire sélectionnées, la première tension est égale à une tension positive, et la seconde tension est égale à une seconde tension de référence inférieure à la première tension de référence.

Selon un mode de réalisation de l'invention, durant une phase de programmation des cellules mémoire sélectionnées, des verrous de programmation appliquent une tension positive à des lignes de bits reliées aux cellules mémoire sélectionnées.

Selon un mode de réalisation de l'invention, la seconde tension de référence est nulle, et la première tension de référence est comprise entre 2 et 5 Volts.

Ces objets, caractéristiques et avantages ainsi que d'autres de la présente invention seront exposés plus en détail dans la description suivante de l'invention faite à titre non limitatif en relation avec les figures jointes parmi lesquelles:
- la figure 1 précédemment décrite représente une cellule mémoire d'une mémoire EEPROM classique ;
- les figures 2A et 2B précédemment décrites sont respectivement des vues de dessus et en coupe transversale d'une cellule mémoire d'une mémoire EEPROM classique ;
- la figure 3 précédemment décrite représente schématiquement l'architecture d'une mémoire EEPROM classique ;
- la figure 4 précédemment décrite représente l'architecture d'un ensemble de lignes de mot d'une mémoire EEPROM classique ;
- la figure 5 représente schématiquement l'architecture d'une mémoire EEPROM selon la présente invention ; et
- les figures 6 à 8 représentent des cellules mémoire de la mémoire EEPROM montrée sur la figure 5 pour illustrer des opérations d'effacement et de programmation ; et

La figure 9 illustre une mémoire EEPROM selon l'invention.

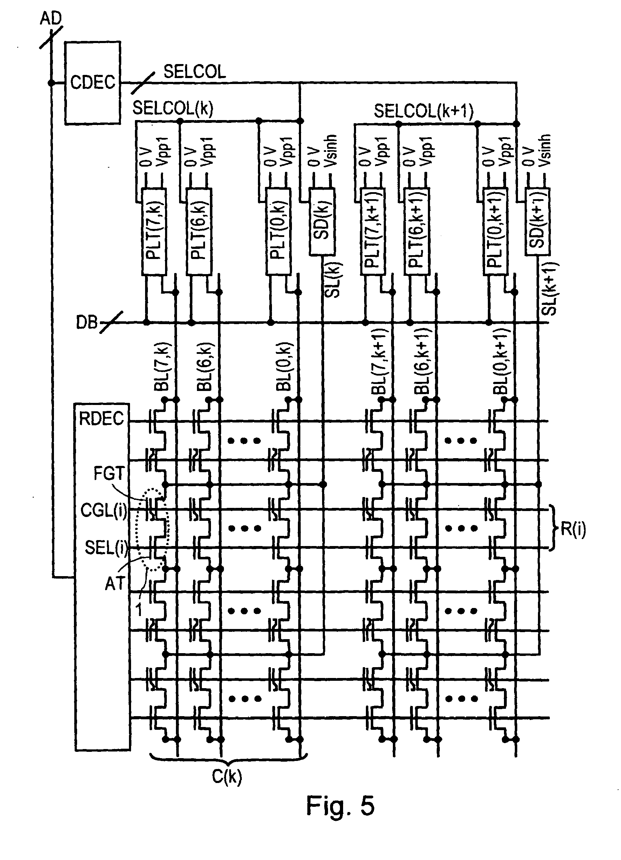

La figure 5 représente une mémoire EEPROM selon l'invention comprenant un décodeur de ligne RDEC, un décodeur de colonne CDEC, et des cellules mémoire 1. Chaque cellule mémoire comporte de façon classique un transistor à grille flottante FGT en série avec un transistor d'accès AT, ici de type MOS.

Les cellules mémoire sont agencées en lignes de mot R(i), et les transistors d'accès AT des cellules mémoire sont reliées par leur drain à des lignes de bit BL(j,k) (j étant un indice compris entre 0 à 7 sur la figure 5) quoi sont transversales aux lignes de mot. Les lignes de bit sont regroupées en colonnes C(k) pour former le long des lignes de mot R(i) des groupes de cellules mémoires comprenant M cellules mémoire chacun et permettant de mémoriser un mot binaire de M bits.

Les lignes de bit BL(j,k) sont connectées à des verrous de programmation PLT(j,k) qui sont pilotés par des signaux de sélection de colonne SELCOL(k) fournis par le décodeur CDEC. Plus particulièrement, les verrous de programmation des lignes de bit d'une même colonne sont pilotés par le même signal de sélection de colonne. Les verrous de programmation sont par ailleurs reliés à un bus de donnée DB de la mémoire et fournissent, en phase de programmation de cellules mémoire, une tension de programmation Vpp1. Cette tension programmation n'est fournie que si le bit reçu via le bus de donnée présente la valeur logique de programmation (par exemple la valeur 1), car dans le cas contraire (valeur 0) la cellule mémoire visée doit rester dans l'état effacé.

Toujours de façon classique, les grilles des transistors d'accès AT des cellules mémoire d'une même ligne de mot R(i) sont reliées à une ligne de sélection SEL(i) commune, qui est pilotée par le décodeur de ligne RDEC.

Selon l'invention, les grilles des transistors FGT de cellules mémoire d'une même ligne de mot R(i) sont reliées à une ligne de contrôle de grille CGL(i) commune, qui est également pilotée par le décodeur de ligne RDEC. Ce dernier comporte à cet effet, pour chaque ligne de mot R(i), une sortie spéciale distincte de la sortie contrôlant la ligne de sélection SEL(i).

Toujours selon l'invention, les lignes de source des cellules mémoire d'une même colonne C(k) sont connectées à une ligne de source commune SL(k). Cette ligne de source SL(k) est pilotée par une unité de contrôle de colonne SD(k), la mémoire comprenant autant d'unités de contrôle de colonne que de colonnes à sélectionner individuellement, pour des raisons qui apparaîtront plus loin.

Ainsi, la répartition des cellules mémoire en colonnes pour obtenir des groupes de cellules mémoire est obtenue ici par la prévision de lignes de source SL(k) communes à toutes les cellules mémoire d'une même colonne C(k), au lieu d'être obtenue par la prévision des transistors de contrôle de grille comme cela est le cas dans l'art antérieur. Il s'ensuit que la ligne de contrôle CGL(i) d'une ligne de mot R(i) peut être utilisée pour contrôler tous les transistors FGT des cellules mémoire de la ligne de mot R(i), comme indiqué plus haut.

Les unités de contrôle de colonne SD(k) sont par exemple des commutateurs de tension ou des commutateurs à verrou (latches). Les unités de contrôle de colonne SD(k) sont pilotées par les signaux de sélection de colonne SELCOL (k) fournis par le décodeur de colonne CDEC, et appliquent aux lignes de source des tensions différentes selon que les colonnes correspondantes sont sélectionnées ou non par le décodeur CDEC. Ainsi, en phase d'effacement de cellules mémoire, les unités de contrôle de colonne SD(k) appliquent aux lignes de source soit une tension nulle (masse) soit une tension d'inhibition Vsinh.

Le décodeur de ligne RDEC et le décodeur de colonne CDEC reçoivent respectivement les bits de poids fort et les bits de poids faible d'une adresse circulant sur le bus d'adresse AD. Le décodeur RDEC applique des signaux de commande aux lignes CGL(i) et aux lignes SEL(i). Le décodeur CDEC applique les signaux de sélection de colonne SELCOLk aux unités de contrôle de colonne SD(k) et aux verrous de programmation PLT(j,k). Ces divers signaux sont fonction de l'adresse présente sur le bus AD. Comme les verrous de programmation PLT(j,k) reçoivent les signaux de sélection de colonne SELCOL(k), tous les verrous d'une même colonne sont activés simultanément lors de l'activation de l'unité de contrôle de colonne SD(k) correspondante, ce qui permet de programmer simultanément les cellules mémoire d'un même groupe.

Par rapport à l'architecture classique décrite en référence à la figure 3, l'architecture selon la présente invention ne comporte pas de transistor CGT de contrôle de grille. Il en résulte que la tension applicable en effacement sur les grilles de contrôle n'est plus limitée par la tension susceptible d'être délivrée par les transistors de contrôle de grille. La suppression des transistors de contrôle de grille permet également de réduire la surface occupée par la mémoire EEPROM pour une même capacité de stockage.

Pour chaque colonne C(k) et chaque ligne de mot R(i), les opérations d'effacement et de programmation des cellules mémoire sont réalisées à l'aide :
- des verrous de programmation PLT (j, k) qui pilotent les lignes de bit BL(j,k) de la colonne sélectionnée,
- du décodeur RDEC de lignes de mot R(i) qui pilote la ligne de contrôle de grille CGL(i) et la ligne de sélection SEL(i) de la ligne de mot sélectionnée, et
- des unités de contrôle de colonne SD(k).

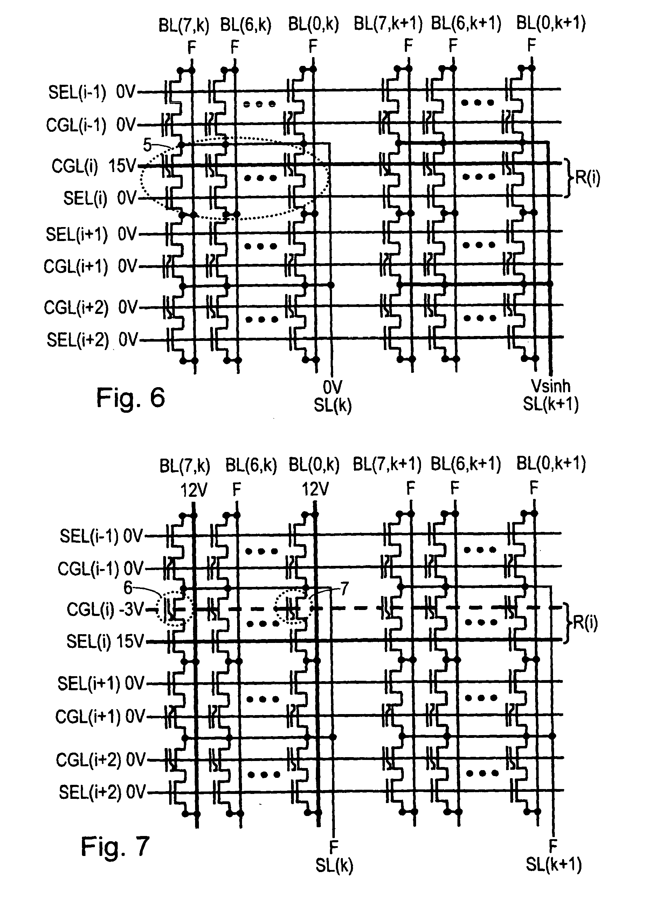

La figure 6 montre le même ensemble de cellules mémoire que celui représenté sur la figure 5 et illustre une opération d'effacement d'un groupe 5 de cellules mémoire. L'effacement des cellules mémoire d'une ligne de mot R(i) est effectué en appliquant à la ligne CGL(i) de contrôle de grille correspondante (ligne CGL(i) montrée en trait plus épais sur la figure 6) une tension positive Vpp2, comprise entre 12 et 18 V, et de préférence égale à 15 V. Simultanément, les autres lignes de contrôle de grille CGL(1) (avec 1 ≠ i), et toutes les lignes de sélection SEL(i) et les lignes de source SL(k) sont portées à un potentiel de référence Vref1, par exemple égal à 0 volt (reliées à la masse). En outre, toutes les lignes de bit BL(j,k) sont simultanément portées à un potentiel flottant ou à haute impédance.

L'invention permet de n'effacer que les cellules mémoire d'un groupe 5 (c'est-à-dire un mot) appartenant à une colonne C(k) et une ligne de mot R(i). A cet effet, seule la ligne de source SL(k) de la colonne C(k) reçoit la tension de référence Vref1, pendant que toutes les autres lignes de sources SL(n) (avec n ≠ k), par exemple la ligne de source SL(k+1) représentée en trait plus épais sur la figure, reçoivent une tension d'inhibition Vsinh comprise entre 10 et 15 V, et de préférence égale à 12 V. De cette manière, la chute de tension entre la grille de contrôle CG et le drain des transistors FGT est égal à 15 - 12 = 3 V, ce qui est insuffisant pour induire une extraction d'électrons par effet tunnel à travers la couche d'oxyde tunnel des transistors à grille flottante. Par ailleurs, cette tension d'inhibition Vsinh n'a pas d'effet sur les cellules mémoire auxquelles elle est appliquée puisque même si celles-ci sont dans l'état programmé (avec une tension de seuil légèrement négative), la tension transférée vers le drain est négligeable (quelques). Ces dispositions permettent d'obtenir une mémoire EEPROM effaçable par mot.

La figure 7 montre le même ensemble de cellules mémoire que celui représenté sur la figure 5, et illustre une opération de programmation de cellules mémoire 6, 7 appartenant à un groupe préalablement effacé situé dans une colonne C(k) et appartenant à une ligne de mot R(i). Cette opération comprend les opérations suivantes :
- appliquer une tension Vpp1 aux lignes de bits BL(j,k) des cellules mémoire 6, 7 à programmer, tout en portant toutes les autres lignes de bits à un potentiel flottant,
- appliquer la tension Vpp2 à la ligne SEL(i) (montrée en trait plus épais) de la ligne de mot R(i), tandis que les lignes de sélection des autres lignes de mot sont portées au potentiel de référence Vref1 (reliées à la masse),
- appliquer une tension de référence Vref2 inférieure à la tension Vref1, comprise entre -2 et -5 V, et de préférence égale à -3 V, à la ligne de contrôle de grille CGL(i) (montrée en trait interrompu sur la figure 7) de la ligne de mot R(i), et
- porter toutes les lignes de source SL(k) à un potentiel flottant.

Le tableau 2 ci-après résume les valeurs des signaux de contrôle pendant les opérations d'effacement et de programmation.

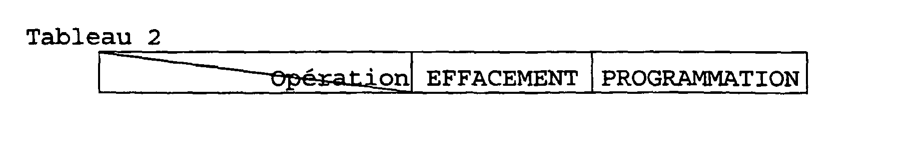

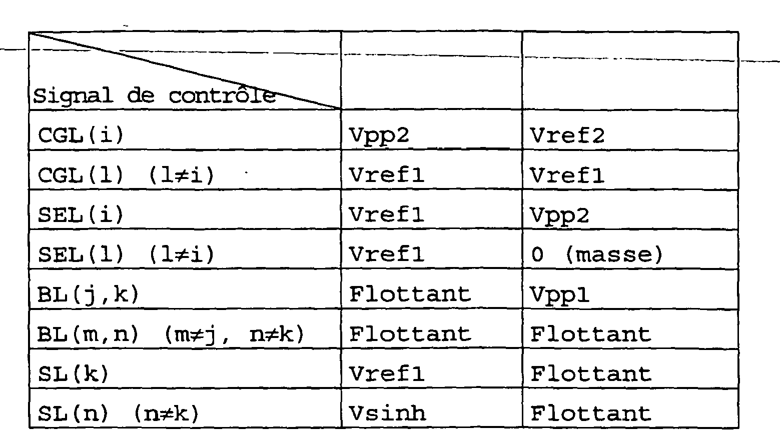

Les tensions de lecture sont les mêmes que celles indiquées dans le tableau 1. Dans l'exemple des figures 6 et 7, la tension Vref1 est égale à 0 V (masse), et la tension Vref2 est égale à -3 V.

L'application d'une tension négative à la ligne CGL(i) de contrôle de grille des cellules à programmer, tandis que la ligne de sélection SEL(i) associée est à 15 V permet d'augmenter l'écart de tension entre le drain et la grille de contrôle des transistors FGT, et donc augmente la vitesse de programmation des cellules mémoire. L'architecture de mémoire selon l'invention présente donc également l'avantage de ne pas limiter le niveau de tension applicable aux grilles de contrôle CG à une tension inférieure à la tension de claquage des jonctions entre les régions dopées n+ et le substrat p. Par ailleurs, il est à noter que dans l'architecture antérieure représentée sur les figures 3, 4, les transistors de contrôle de grille CGT ne permettent pas d'appliquer une tension négative sur les grilles de contrôle des transistors FGT.

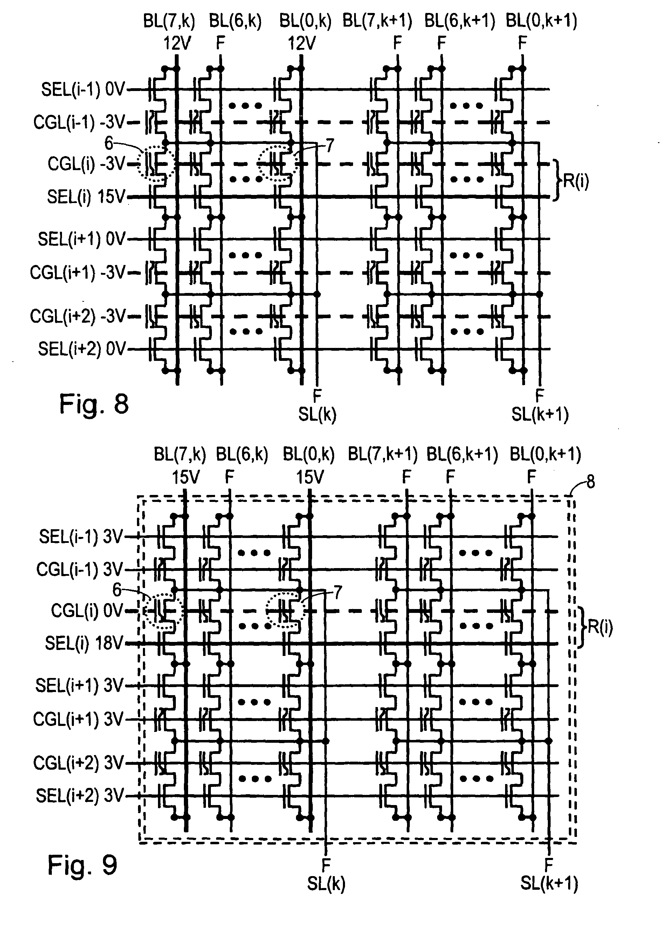

Si la technologie employée pour réaliser la mémoire ne permet pas de prévoir un décodeur capable d'appliquer une tension négative sur une seule ligne (impossibilité de réaliser un triple caisson dans le substrat), la tension négative Vref2 peut alors être appliquée à toutes les lignes CGL(i) de contrôle de grille (montrées en trait interrompu sur la figure 8).

Dans l'invention illustrée sur la figure 9, la mémoire est réalisée dans un double caisson np 8 formé dans un substrat p. Le double caisson est polarisé à une tension positive comprise entre 2 et 5 V, et de préférence égale à 3 V, ce qui permet d'augmenter de la même valeur (3 V) la tension appliquée sur les lignes de bit BL, soit 15 V au lieu de 12 V dans l'exemple des figures. La tension appliquée à la ligne SEL(i) de sélection du mot auxquelles appartiennent les cellules 6, 7 à programmer est également augmentée d'autant, soit 18 V dans l'exemple représenté sur les figures. De même, les potentiels flottants appliqués aux lignes de bit BL(j,k) et aux lignes de source SL(k) doivent être voisins ou supérieurs à 3 V. Cette condition est réalisée en portant simplement les lignes de bit à un potentiel flottant, puisque celles-ci sont polarisées par l'intermédiaire du double caisson. On peut également utiliser un montage suiveur permettant d'empêcher que la tension appliquée aux lignes de bit soit inférieure à 3 V.

Alternativement, dans une variante illustrée sur la figure 9, une tension nulle est appliquée à toutes les lignes de contrôle de grille CGL(i).

La présente invention est bien entendu susceptible de diverses autres variantes à la portée de l'homme de l'art, tant en ce qui concerne le choix des tensions à appliquer sur les transistors des cellules mémoire pendant les opérations d'effacement, et de programmation, et le choix des moyens permettant d'appliquer ces tensions.

En particulier, l'invention permet de réaliser une EEPROM effaçable par page (une page correspondant à toutes les cellules mémoire d'une ligne de mot), en connectant toutes les lignes de source à une seule unité de contrôle de colonne.

## Revendications

1. Mémoire effaçable et programmable électriquement comprenant :
- des cellules mémoire (1) agencées selon des lignes de mot (R(i)), chaque cellule mémoire comprenant un transistor à grille flottante (FGT) agencé en série avec un transistor d'accès (AT),
- des lignes de sélection (SEL(i)) de lignes de mot (R(i)) connectées chacune aux grilles des transistors d'accès (AT) des cellules mémoire d'une ligne de mot respective,
- des lignes de bit (BL(j,k)) transversales aux lignes de mot et reliées aux cellules mémoire, les lignes de bit étant regroupées en colonnes (C(k)) sélectionnables individuellement,
- des lignes de contrôle de grille (CGL(i)) communes connectées chacune aux grilles de contrôle des transistors à grille flottante (FGT) des cellules mémoire d'une ligne de mot (R(i)) respective,
- des lignes de source (SL(k)) communes qui sont connectées chacune aux cellules mémoire d'une colonne respective, et
- des unités de contrôle de colonne (SD(k)) pilotant chacune une ligne de source respective,
**caractérisée en ce qu'**elle comprend un double caisson (8) dans un substrat semi-conducteur, dans lequel sont formées les cellules mémoire (1), et des moyens pour polariser le double caisson à une tension de polarisation positive durant des opérations de programmation de cellules mémoire.

2. Mémoire selon la revendication 1, dans laquelle l'unité de contrôle de colonne (SD(k)) de chaque colonne (C(k)) reçoit un signal de sélection de colonne (SELCOL(k)) et est agencée pour appliquer des tensions différentes (Vref1, Vsinh) à la ligne de source de la colonne selon que la colonne est sélectionnée ou non.

3. Mémoire selon la revendication 2, dans laquelle, pendant une phase d'effacement de cellules mémoire d'une colonne (C(k)) sélectionnée :
- l'unité de contrôle de colonne (SD(k)) de la colonne sélectionnée applique une première tension (Vref1) à la ligne de source de la colonne sélectionnée, et
- l'unité de contrôle de colonne (SD(k+1)) d'une colonne non sélectionnée applique à la ligne de source de la colonne non sélectionnée une tension (Vsinh) d'inhibition d'effacement.

4. Mémoire selon l'une des revendications 1 à 3, dans laquelle, pendant une phase d'effacement de cellules mémoire (5) d'une ligne de mot (R(i)) sélectionnée, une unité de décodage de ligne (RDEC) applique une tension positive (Vpp2) et une tension de référence (Vref1) respectivement à la ligne de contrôle de grille (CGL(i)) et à la ligne de sélection (SEL(i)) de la ligne de mot sélectionnée.

5. Mémoire selon l'une des revendications 1 à 4, dans laquelle, pendant une phase de programmation de cellules mémoire (6, 7) d'une ligne de mot (R(i)) sélectionnée, une unité de décodage de ligne (RDEC) applique :
- une première tension de référence positive (Vref1) à la ligne de contrôle de grille d'une ligne de mot non sélectionnée,
- une seconde tension de référence nulle (Vref2) inférieure à la première tension de référence à la ligne de contrôle de grille (CGL(i)) de la ligne de mot (R(i)) sélectionnée, et
- une tension positive (Vpp2) à la ligne de sélection (SEL(i)) de la ligne de mot (R(i)) sélectionnée.

6. Mémoire selon la revendication 5, dans laquelle la première tension de référence (Vref1) est une tension positive inférieure à la tension positive (Vpp2), et la seconde tension de référence (Vref2) est nulle.

7. Mémoire selon la revendication 6, dans laquelle la tension positive (Vpp2) est comprise entre 15 et 21 V, et la première tension de référence (Vref1) est comprise entre 2 et 5 V.

8. Mémoire selon l'une des revendications 1 à 7, dans laquelle, des verrous de programmation (PLT(j,k)) de lignes de bit placent sélectivement les lignes de bits à un potentiel flottant, et à une première tension de référence (Vref1).

9. Mémoire selon l'une des revendications 1 à 8, dans laquelle, pendant une opération de programmation de cellules mémoire (6, 7) reliées à des lignes de bit sélectionnées, des verrous de programmation (PLT(j,k)) des lignes de bit sélectionnées appliquent une seconde tension positive (Vpp1) aux lignes de bits sélectionnées.

10. Procédé de sélection de cellules mémoire dans une mémoire effaçable et programmable électriquement comprenant :
- des cellules mémoire comprenant chacune un transistor à grille flottante (FGT) agencé en série avec un transistor d'accès (AT), les cellules mémoire étant réalisées dans un double caisson (8) formé dans un substrat semiconducteur, et agencées selon des lignes de mot (R(i)) et selon des colonnes de mot (C(k)) transversales aux lignes de mot,
- des lignes de sélection (SEL(i))connectées chacune aux grilles des transistors d'accès (AT) des cellules mémoire d'une ligne de mot respective,
- des lignes de contrôle de grille (CGL(i)) connectées chacune aux grilles des transistors à grille flottante (FGT) des cellules mémoire d'une ligne de mot respective,
- des lignes de sélection de colonne (SL(k)) reliées chacune aux transistors à grille flottante des cellules mémoire d'une colonne respective,
le procédé comprenant des étapes de :
- polarisation du double caisson (8) à une tension de polarisation positive,
- application d'une première tension positive de référence (Vref1) à une ligne de contrôle de grille (CGL(1)) d'une ligne de mot non sélectionnée,
- application d'une première tension positive (Vref1, Vpp2) à la ligne de sélection (SEL(i)) d'une ligne de mot (R(i)) sélectionnée, et
- application d'une seconde tension positive ou nulle (Vpp2, Vref2) à la ligne de contrôle de grille (CGL(i)) de la ligne de mot sélectionnée.

11. Procédé selon la revendication 10, dans lequel, durant une phase d'effacement de cellules mémoire sélectionnée
- la première tension de référence (Vref1) est appliquée à une ligne de sélection de colonne (SL(k)) d'une colonne sélectionnée, et
- une tension d'inhibition d'effacement (Vsinh) distincte de la première tension de référence est appliquée à une ligne de sélection de colonne (SL(k+1)) d'une colonne non sélectionnée.

12. Procédé selon la revendication 10 ou 11, dans lequel pendant une phase d'effacement des cellules mémoire sélectionnées, la seconde tension est une tension positive (Vpp2), la première tension est égale à la première tension de référence (Vref1).

13. Procédé selon la revendication 11 ou 12, dans lequel la tension positive (Vpp2) est comprise entre 15 et 21 V, et la tension d'inhibition (Vsinh) est comprise entre 10 et 15 V.

14. Procédé selon l'une des revendications 10 à 13, dans lequel pendant une phase de programmation des cellules mémoire sélectionnées, la première tension est égale à une tension positive (Vpp2), et la seconde tension est égale à une seconde tension de référence (Vref2) inférieure à la première tension de référence (vref1).

15. Procédé selon l'une des revendications 10 à 14, dans lequel durant une phase de programmation des cellules mémoire sélectionnées, des verrous de programmation (PLT(j,k)) appliquent une tension positive (Vpp1) à des lignes de bits reliées aux cellules mémoire (6, 7) sélectionnées.

16. Procédé de programmation selon la revendication 14 ou 15, dans lequel la seconde tension de référence (Vref2) est nulle, et la première tension de référence (Vref1) est comprise entre 2 et 5 Volt.

## Claims

1. Electrically erasable and programmable memory comprising:
- memory cells (1) arranged according to word lines (R(i)), each memory cell comprising a floating gate transistor (FGT) arranged in series with an access transistor (AT),
- word line (R(i)) selection lines (SEL(i)), each connected to the gates of the access transistors (AT) of the memory cells of a respective word line,
- bit lines (BL(j,k)) transverse to the word lines and linked to the memory cells, the bit lines being gathered into individually selectable columns (C(k)),
- common gate control lines (CGL(i)), each connected to the control gates of the floating gate transistors (FGT) of the memory cells of a respective word line (R(i)),
- common source lines (SL(k)), each connected to the memory cells of a respective column, and
- column control units (SD(k)), each driving a respective source line,
**characterised in that** it comprises a double housing (8) in a semi-conductor substrate, wherein the memory cells (1) are formed, and means for biasing the double housing at a positive bias voltage during operations for programming memory cells.

2. Memory according to claim 1, wherein the column control unit (SD(k)) of each column (C(k)) receives a column selection signal (SELCOL(k)) and is arranged to apply different voltages (Vref1, Vsinh) to the source line of the column depending on whether the column is selected or not.

3. Memory according to claim 2, wherein, during a phase for erasing memory cells from a selected column (C(k)):
- the column control unit (SD(k)) of the selected column applies a first voltage (Vref1) to the source line of the selected column, and
- the column control unit (SD(k+1)) of a not selected column applies to the source line of the not selected column an erase inhibit voltage (Vsinh).

4. Memory according to one of claims 1 to 3, wherein, during a phase for erasing memory cells (5) from a selected word line (R(i)), a line decoding unit (RDEC) applies a positive voltage (Vpp2) and a reference voltage (Vref1) respectively to the gate control line (CGL(i)) and the selection line (SEL(i)) of the selected word line.

5. Memory according to one of claims 1 to 4, wherein, during a phase for programming memory cells (6,7) of a selected word line (R(i)), a line decoding unit (RDEC) applies:
- a first positive reference voltage (Vref1) to the gate control line of a not selected word line,
- a second reference voltage equal to zero (Vref2) lower than the first reference voltage to the gate control line (CGL(i)) of the selected word line (R(i)), and
- a positive voltage (Vpp2) to the selection line (SEL(i)) of the selected word line (R(i)).

6. Memory according to claim 5, wherein the first reference voltage (Vref1) is a positive voltage lower than the positive voltage (Vpp2), and the second reference voltage (Vref2) is equal to zero.

7. Memory according to claim 6, wherein the positive voltage (Vpp2) is comprised between 15 and 21 V, and the first reference voltage (Vref1) is comprised between 2 and 5 V.

8. Memory according to one of claims 1 to 7, wherein bit line programming locks (PLT(j,k)) selectively bring the bit lines to a floating potential, and to a first reference voltage (Vref1).

9. Memory according to one of claims 1 to 8, wherein, during an operation for programming memory cells (6,7) linked to selected bit lines, locks for programming (PLT(j,k)) selected bit lines apply a second positive voltage (Vpp1) to the selected bit lines.

10. Method for selecting memory cells in an electrically erasable and programmable memory comprising:
- memory cells, each comprising a floating gate transistor (FGT) arranged in series with an access transistor (AT), the memory cells being made in a double housing (8) formed in a semiconductor substrate, and arranged according to word lines (R(i)) and according to word columns (C(k)) transverse to the word lines,
- selection lines (SEL(i)), each connected to the gates of the access transistors (AT) of the memory cells of a respective word line,
- gate control lines (CGL(i)), each connected to the gates of the floating gate transistors (FGT) of the memory cells of a respective word line,
- column selection lines (SL(i)), each linked to the floating gate transistors of the memory cells of a respective column, the method comprising steps of:
- biasing the double housing (8) to a positive bias voltage,
- applying a first positive reference voltage (Vref1) to a gate control line (CGL(1)) of a not selected word line,
- applying a first positive voltage (Vref1, Vpp2) to the selection line (SEL(i)) of a selected word line (R(i)), and
- applying a second voltage, positive or equal to zero, (Vpp2, Vref2) to the gate control line (CGL(i)) of the selected word line.

11. Method according to claim 10, wherein, during a phase for erasing selected memory cells:
- the first reference voltage (Vref1) is applied to a column selection line (SL(k)) of a selected column, and
- an erase inhibit voltage (Vsinh) different from the first reference voltage is applied to a column selection line (SL(k+1)) of a not selected column.

12. Method according to claim 10 or 11, wherein, during a phase for erasing selected memory cells, the second voltage is a positive voltage (Vpp2), the first voltage is equal to the first reference voltage (Vref1).

13. Method according to claim 11 or 12, wherein the positive voltage (Vpp2) is comprised between 15 and 21 V, and the inhibit voltage (Vsinh) is comprised between 10 and 15 V.

14. Method according to one of claims 10 to 13, wherein, during a phase for programming selected memory cells, the first voltage is equal to a positive voltage (Vpp2), and the second voltage is equal to a second reference voltage (Vref2) lower than the first reference voltage (Vref1).

15. Method according to one of claims 10 to 14, wherein, during a phase for programming selected memory cells, programming locks (PLT(j,k)) apply a positive voltage (Vpp1) to bit lines linked to the selected memory cells (6,7).

16. Programming method according to claim 14 or 15, wherein the second reference voltage (Vref2) is equal to zero, and the first reference voltage (Vref1) is comprised between 2 and 5 Volts.

## Patentansprüche

1. Elektrisch löschbarer und programmierbarer Speicher mit:
- Speicherzellen (1), die entlang von Wortzeilen (R(i)) angeordnet sind, wobei jede Speicherzelle einen Transistor mit offenem Gitter (FGT) aufweist, der mit einem Zugangstransistor (AT) in Serie geschaltet ist,
- Auswahlzeilen (SEL(i)) von Wortzeilen (R(i)), die jeweils mit den Gittern der Zugangstransistoren (AT) der Speicherzellen einer jeweiligen Wortzeile verbunden sind,
- Bitzeilen (BL(j, k)) quer zu den Wortzeilen und mit den Speicherzellen verbunden, wobei die Bitzeilen in Spalten (C(k)), die einzeln ausgewählt werden können, gruppiert sind,
- gemeinsame Gittersteuerzeilen (CGL(i)), die jeweils mit den Steuergittern der Transistoren mit offenem Gitter (FGT) der Speicherzellen einer jeweiligen Wortzeile (R(i)) verbunden sind,
- gemeinsame Quellenzeilen (SL(k)), die jeweils mit den Speicherzellen einer jeweiligen Spalte verbunden sind, und
- Spaltensteuereinheiten (SD(k)), die jeweils eine jeweilige Quellenzeile steuern,
**dadurch gekennzeichnet, dass** er ein doppeltes Gehäuse (8) in einem Halbleitersubstrat aufweist, in dem die Speicherzellen (1) ausgebildet sind, und Mittel zum Polarisieren des doppelten Gehäuses mit einer positiven Polarisierungsspannung während der Programmieroperationen von Speicherzellen.

2. Speicher nach Anspruch 1, bei dem die Spaltensteuereinheit (SD(k)) jeder Spalte (C(k)) ein Spaltenauswahlsignal (SELCOL(k)) empfängt und eingerichtet ist, um unterschiedliche Spannungen (Vref1, Vsinh) auf die Quellenzeile der Spalte je nachdem anzulegen, ob die Spalte ausgewählt ist oder nicht.

3. Speicher nach Anspruch 2, bei dem während einer Löschphase von Speicherzellen einer ausgewählten Spalte (C(k)):
- die Spaltensteuereinheit (SD(k)) der ausgewählten Spalte eine erste Spannung (Vref1) auf die Quellenzeile der ausgewählten Spalte anlegt, und
- die Spaltensteuereinheit (SD(k+1)) einer nicht ausgewählten Spalte auf die Quellenzeile der nicht ausgewählten Spalte eine Spannung (Vsinh) zum Inhibieren des Löschens anlegt.

4. Speicher nach einem der Ansprüche 1 bis 3, bei dem während einer Löschphase von Speicherzellen (5) einer ausgewählten Wortzeile (R(i)) eine Zeilendecodiereinheit (RDEC) eine positive Spannung (Vpp2) und eine Referenzspannung (Vref1) jeweils auf die Gittersteuerzeile (CGL(i)) und auf die Auswahlzeile (SEL(i)) der ausgewählten Wortzeile anlegt.

5. Speicher nach einem der Ansprüche 1 bis 4, bei dem während einer Programmierphase von Speicherzellen (6, 7) einer ausgewählten Wortzeile (R(i)) eine Zeilendecodiereinheit (RDEC) Folgendes anlegt:
- eine erste positive Referenzspannung (Vref1) auf die Gittersteuerzeile einer nicht ausgewählten Wortzeile,
- eine zweite Referenzspannung gleich Null (Vref2), die kleiner ist als die erste Referenzspannung, auf die Gittersteuerzeile (CGL(i)) der ausgewählten Wortzeile (R(i)), und
- eine positive Spannung (Vpp2) auf die Auswahlzeile (SEL(i)) der ausgewählten Wortzeile (R(i)).

6. Speicher nach Anspruch 5, bei dem die erste Referenzspannung (Vref1) eine positive Spannung ist, die niedriger ist als die positive Spannung (Vpp2) und bei dem die zweite Referenzspannung (Vref2) gleich Null ist.

7. Speicher nach Anspruch 6, bei dem die positive Spannung (Vpp2) zwischen 15 und 21 Volt und die erste Referenzspannung (Vref1) zwischen 2 und 5 V liegt.

8. Speicher nach einem der Ansprüche 1 bis 7, bei dem Programmiersperren (PLT(j, k)) von Bitzeilen selektiv die Bitzeilen auf ein schwimmendes Potenzial und auf eine erste Referenzspannung (Vref1) stellen.

9. Speicher nach einem der Ansprüche 1 bis 8, bei dem während einer Programmieroperation von Speicherzellen (6, 7), die mit ausgewählten Bitzeilen verbunden sind, Programmiersperren (PLT(j, k)) der ausgewählten Bitzeilen eine zweite positive Spannung (Vpp1) auf die ausgewählten Bitzeilen anlegen.

10. Verfahren zum Auswählen von Speicherzellen in einem elektrisch löschbaren und programmierbaren Speicher, Folgendes aufweisend:
- Speicherzellen, die jeweils einen Transistor mit offenem Gitter (FGT) aufweisen, der mit einem Zugangstransistor (AT) in Serie geschaltet ist, wobei die Speicherzellen in einem doppelten Gehäuse (8) hergestellt sind, das in einem Halbleitersubstrat ausgebildet ist, und gemäß Wortzeilen (R(i)) und Wortspalten (C(k)) quer zu den Wortzeilen eingerichtet sind,
- Auswahlzeilen (SEL(i)), die jeweils mit den Gittern der Zugangstransistoren (AT) der Speicherzellen einer jeweiligen Wortzeile verbunden sind,
- Gittersteuerzeilen (CGL(i)), die jeweils mit den Gittern der Transistoren mit offenem Gitter (FGT) der Speicherzellen einer jeweiligen Wortzeile verbunden sind,
- Spaltenauswahlzeilen (SL(k)), die jeweils mit den Transistoren mit offenem Gitter der Speicherzellen einer jeweiligen Spalte verbunden sind,
wobei das Verfahren die folgenden Schritte aufweist:
- Polarisierung des doppelten Gehäuses (8) mit einer positiven Polarisierungsspannung,
- Anlegen einer ersten positiven Referenzspannung (Vref1) auf eine Gittersteuerzeile (CGL(1) einer nicht ausgewählten Wortzeile,
- Anlegen einer ersten positiven Spannung (Vref1, Vpp2) auf die Auswahlzeile (SEL(i)) einer ausgewählten Wortzeile (R(i)), und
- Anlegen einer zweiten positiven Spannung oder Spannung gleich Null (Vpp2, Vref2) auf die Gittersteuerzeile (CGL(i)) der ausgewählten Wortzeile.

11. Verfahren nach Anspruch 10, bei dem während einer Löschphase von ausgewählten Speicherzellen:
- die erste Referenzspannung (Vref1) auf eine Spaltenauswahlzeile (SL(k)) einer ausgewählten Spalte angelegt wird, und
- eine Löschinhibitionsspannung (Vsinh), die von der ersten Referenzspannung unterschiedlich ist, auf eine Spaltenauswahlzeile (SL(k+1)) einer nicht ausgewählten Spalte angelegt wird.

12. Verfahren nach Anspruch 10 oder 11, bei dem während einer Löschphase der ausgewählten Speicherzellen die zweite Spannung eine positive Spannung (Vpp2) ist, die erste Spannung gleich der ersten Referenzspannung (Vrewf1) ist.

13. Verfahren nach Anspruch 11 oder 12, bei dem die positive Spannung (Vpp2) zwischen 15 und 21 V liegt, und die Inhibitionsspannung (Vsinh) zwischen 10 und 15 V liegt.

14. Verfahren nach einem der Ansprüche 10 bis 13, bei dem während einer Programmierphase der ausgewählten Speicherzellen die erste Spannung gleich einer positiven Spannung (Vpp2) und die zweite Spannung gleich einer zweiten Referenzspannung (Vref2) ist, die kleiner ist als die erste Referenzspannung (Vref1).

15. Verfahren nach einem der Ansprüche 10 bis 14, bei dem während einer Programmierphase der ausgewählten Speicherzellen Programmiersperren (PLT(j, k)) eine positive Spannung (Vpp1) auf Bitzeilen anlegen, die mit den ausgewählten Speicherzellen (6, 7) verbunden sind.

16. Programmierverfahren nach Anspruch 14 oder 15, bei dem die zweite Referenzspannung (Vref2) Null ist und die erste Referenzspannung (Vref1) zwischen 2 und 5 Volt liegt.
